# EUROPÄISCHE PATENTSCHRIFT

(11) **EP 0 600 276 B1**
(45) Veröffentlichungstag und Bekanntmachung des Hinweises auf die Patenterteilung: **05.08.1998**
(21) Anmeldenummer: 93118225.7
(22) Anmeldetag: 10.11.1993
(51) Int. Cl.: C30B 25/04, C30B 23/04, H01L 21/20, H01L 21/331, H01L 21/336, H01L 21/302

(54) **Verfahren zur Herstellung eines seitlich begrenzten, einkristallinen Gebietes mittels selektiver Epitaxie und dessen Anwendung zur Herstellung eines Bipolartransistors sowie eines MOS-transistors**
Process for production of a laterally limited monocrystal area by selective epitaxy and its application for production of a bipolar transistor as well as well as a MOS-transistor
Procédé de production d'une zone monocristalline limitée latéralement par épitaxie sélective et son utilisation pour produire un transistor bipolaire ainsi qu'un transistor MOS

(30) Priorität: 04.12.1992 DE 4240924
(43) Veröffentlichungstag der Anmeldung: 08.06.1994
(73) Patentinhaber: SIEMENS AKTIENGESELLSCHAFT, 80333 München (DE)
(72) Erfinder: Meister, Thomas, F., Dr., D-82024 Taufkirchen (DE); Stengl, Reinhard, Dr., IBM East Fishkill Facility, Hopewell Junction, N.Y. 12533 (US)

(56) Entgegenhaltungen:
- EP-A- 0 042 698
- EP-A- 0 057 587
- US-A- 3 639 186
- INTERNATIONAL ELECTRON DEVICES, 09.-12. Dezember 1990 F. SATO et al. "A "Self- Aligned" selective MBE technology for high-perfor- mance bipolar transistors" Seiten 607-610

## Beschreibung

In der Halbleitertechnologie wird bei der Herstellung elektrisch aktiver Gebiete zunehmend selektive Epitaxie eingesetzt. Vor der selektiven Epitaxie wird auf der Oberfläche eines Substrats eine maskierende Struktur mit einer Öffnung erzeugt, in der die Oberfläche des Substrats freiliegt. Die freiliegende Oberfläche des Substrats besteht aus einem einkristallinen Halbleiter, insbesondere Silizium. Die maskierende Struktur ist so gewählt, daß bei der selektiven Epitaxie ausgehend von der freiliegenden Oberfläche des Substrats einkristallines Halbleitermaterial aufwächst und daß auf der Oberfläche der maskierenden Struktur kein Halbleitermaterial aufwächst. Auf diese Weise entsteht ein einkristallines Gebiet, das vollständig von der maskierenden Struktur umgeben ist. Die maskierende Struktur besteht dabei im wesentlichen aus isolierendem Material und dient zur Isolation des aktiven Gebietes. Bei der selektiven Epitaxie werden die elektrisch aktiven Gebiete in Öffnungen einer isolierenden Schicht aufgewachsen.

Bei konventionellen Isolationsmethoden, wie z. B. LOCOS oder Trench, werden dagegen die zur Isolation erforderlichen Gebiete, z. B. mit Oxid, "dielektrisch aufgefüllt".

Aus J. Borland et al, Solid State Techn., Jan. 1990, S. 73 - 78 ist bekannt, in der Bipolartechnik Kollektor, Basis und/oder Emitter durch selektive Epitaxie zu erzeugen. Auch in der CMOS-Technologie findet die selektive Epitaxie Anwendung. So werden z. B. eine CMOS-Wanne (s. z. B. J. Manoliu et al, IEDM Digest, 1987, S. 20-23) oder Source und Drain (s. z. B. EP-0 268 941 (86 P 1815)) durch selektive Epitaxie aufgefüllt.

Versuche haben jedoch gezeigt, daß mittels selektiver Epitaxie hergestellte Dioden in Bezug auf Leckströme konventionell hergestellten Dioden, z. B. mit Locos-Isolation, unterlegen sind (s. A. Stivers et al, Proc. of l9th Int. Conf. on CVD, Okt 1987, Honolulu, S. 389 - 397). Diese Leckströme werden mit Seitenwanddefekten in Verbindung gebracht. Unter Seitenwanddefekten versteht man Kristallfehler, die entlang der Kanten der aktiven Epitaxieschicht entstehen. Da bei der selektiven Epitaxie das Halbleitermaterial, z. B. Silizium, epitaktisch in der Öffnung der maskierenden Struktur, die z. B. aus SiO₂ oder Si₃N₄ besteht, aufwächst und die aus dielektrischem Material bestehenden Seitenwände der Öffnung eine Quelle für Kristallfehler darstellen, kommt es während der selektiven Abscheidung in diesem Bereich zu Kristallfehlern, die Seitenwanddefekte genannt werden.

Zur Vermeidung der Seitenwanddefekte bei der selektiven Epitaxie ist bekannt (s. z. B. A. Stivers et al, Proc. of 10th Int. Conf. on CVD, Okt. 1987, Honolulu, S. 389-397), die dielektrischen Seitenwände mit Polysilizium oder Nitrid auszukleiden. Desweiteren ist aus C.S. Pai et al, J. Electrochem. Soc., Bd. 137, 1990, S. 971 - 976 bekannt, daß bei speziellen Epitaxiebedingungen das Auftreten von Seitenwanddefekten minimiert wird. Ebenfalls aus C.S. Pai et al, J. Electrochem. Soc., Bd. 137, 1990, S. 971 - 976 ist bekannt, zur Verringerung der Defekte als Unterlage Siliziumsubstrate zu verwenden, in denen die Kanten der aktiven Transistorgebiete entlang (100)-Kristallrichtungen verlaufen. Üblicherweise werden Substrate verwendet, in denen die Kanten der aktiven Transistorgebiete entlang (110)-Richtungen verlaufen. Durch eine Drehung der Transistorstrukturen um 45° ist es möglich, die üblichen (110)-Siliziumsubstrate zu verwenden und dennoch eine Verringerung des Defektniveaus zu erzielen.

Der Erfindung liegt das Problem zugrunde, ein Verfahren zur Herstellung eines seitlich begrenzten, einkristallinen Gebietes mittels selektiver Epitaxie anzugeben, mit dem Seitenwanddefekte in dem einkristallinen Gebiet wirksam unterdrückt werden und daß die Herstellung von einkristallinen Gebieten erlaubt, die eine bei der Verwendung als aktives Gebiet ausreichende Defektfreiheit aufweisen.

Dieses Problem wird erfindungsgemäß gelöst durch ein Verfahren nach Anspruch 1.

Die Erfindung macht sich die Erkenntnis zu nutze, daß Seitenwanddefekte bei der selektiven Epitaxie, bei der eine maskierende Struktur mit einer Öffnung an der Oberfläche eines Substrats aus z. B. einkristallinem Silizium angeordnet ist, im wesentlichen entlang der Grenzfläche Silizium-Dielektrikum, die sich an der unteren Kanten der Öffnung befindet, entstehen. An der Grenzfläche Dielektrikum-epitaktisch aufgewachsenes Gebiet, die sich im mittleren und oberen Teil der Seitenwand der Öffnung befindet, wird dagegen keine Entstehung von Seitenwanddefekten beobachtet. Von der unteren Kante aus wachsen die Defekte unter einem Winkel von etwa 55° in das aktive Gebiet hinein.

Erfindungsgemäß wird die Öffnung in der maskierenden Schicht so gestaltet, daß an der Oberfläche des Substrats der Querschnitt der Öffnung parallel zur Oberfläche des Substrats größer ist als an der Oberfläche der maskierenden Struktur. Dabei überragt der Querschnitt an der Oberfläche des Substrats denjenigen an der Oberfläche der maskierenden Schicht seitlich. Im Bereich der Oberfläche der maskierenden Schicht verläuft die Seitenwand der Öffnung im wesentlichen senkrecht zur Oberfläche des Substrats. Die Seitenwand der Öffnung weist im Querschnitt senkrecht zur Oberfläche des Substrats einen stufenförmigen Verlauf auf. Dadurch zeigt die Seitenwand einen Überhang, unterhalb dessen die Seitenwand zurückversetzt verläuft.

Bei der selektiven Epitaxie wächst das einkristalline Halbleitermaterial, z. B. Silizium von der Oberfläche des Substrats aus auf. Von der Grenzfläche Silizium-Dielektrikum ausgehende Seitenwanddefekte werden durch den Überhang unterbrochen. Es entsteht so ein einkristallines Gebiet, das innerhalb des Querschnitts der Öffnung an der Oberfläche der maskierenden Schicht praktisch defektfrei ist.

Der stufenförmige Verlauf der Seitenwand wird insbesondere in einem Ätzverfahren hergestellt, das die maskierende Schicht verstärkt in der Nähe der Grenzfläche Oberfläche des Substrats- maskierende Schicht angreift.

Es liegt im Rahmen der Erfindung, die maskierende Schicht aus SiO₂ auf einer Oberfläche aus einkristallinem Si zu bilden und die Unterätzung in Wasserstoffatmosphäre bei Temperaturen oberhalb 900 °C durch die Reaktion Si + SiO₂ → 2SiO ↑ zu realisieren. Diese Reaktion ist z. B. aus J. Manoliu et al, IEDM Digest, 1987, S. 20 - 23 zur Reinigung der Substratoberfläche vor der selektiven Epitaxie bekannt. Dabei kann es zu einem unkontrollierten Angriff auf die Oxidseitenwand kommen, der zu unregelmäßigen Kanten in diesem Bereich führt, die eine Quelle für Epitaxiedefekte bilden. Daher wird in der Literatur versucht, diesen Angriff auf die Oxidseitenwand zu unterdrücken.

Erfindungsgemäß wird vorgeschlagen, diese Reaktion kontrolliert zur Unterätzung der Seitenwand mit regelmäßigen Kanten zu verwenden.

Alternativ liegt es im Rahmen der Erfindung, die maskierende Schicht aus mindestens zwei Schichten zusammengesetzt zu bilden, wobei die untere Schicht selektiv zur oberen Schicht und zur Substratoberfläche ätzbar ist. In diesem Fall wird die Unterätzung durch selektives Ätzen der unteren Schicht gebildet. Die untere Schicht dient dabei als Hilfsschicht. Als Hilfsschicht wird auf einem Substrat aus Silizium z. B. eine Si₃N₄-Schicht und als obere Schicht eine SiO₂-Schicht verwendet.

Um Probleme, die an Grenzflächen zwischen Siliziumnitrid und Silizium entstehen, zu vermeiden, liegt es im Rahmen der Erfindung, die Hilfsschicht zusammengesetzt vorzusehen. Unmittelbar auf die Siliziumoberfläche des Substrats wird eine SiO₂-Schicht aufgebracht, darauf eine Si₃N₄ oder Polysiliziumschicht, darauf eine SiO₂-Schicht. Die obere SiO₂-Schicht ist viel dicker als die zusammengesetzte Hilfsschicht. Die Unterätzung wird in diesem Fall durch selektive Ätzung hergestellt, falls die an der Oberfläche angeordnete Oxidschicht und die obere Oxidschicht selektiv zueinander ätzbar sind. Dieses ist z. B. der Fall, wenn die untere Oxidschicht aus Plasmaoxid und die obere Oxidschicht aus dotiertem CVD-Oxid, z. B. BPSG hergestellt wurde.

Sind die beiden Oxidschichten nicht selektiv zueinander ätzbar, so wird die Unterätzung z. B. aufgrund eines Geometrieeffektes erzielt. Dabei wird zunächst in der oberen SiO₂-Schicht und in der Hilfsschicht aus Si₃N₄ oder Polysilizium eine Öffnung gleichen Querschnitts erzeugt. Anschließend wird in einem isotropen Ätzschritt SiO₂ selektiv zu Si₃N₄ oder Polysilizium und der Siliziumoberfläche geätzt. Weist die an der Oberfläche des Substrats angeordnete Oxidschicht eine um einen Faktor von z. B. 10 geringere Dicke auf als die obere Oxidschicht, so wird aus geometrischen Gründen eine Unterätzung unter die Si₃N₄- oder Polysiliziumschicht gebildet, ohne daß der Querschnitt der Öffnung im Bereich der oberen Oxidschicht sich nennenswert ändert.

Eine weitere Möglichkeit zur Herstellung der Unterätzung im Fall von zwei nicht zueinander selektiv ätzbaren SiO₂-Schichten besteht darin, zunächst eine Öffnung gleichen Querschnitts in der oberen SiO₂-Schicht und der Si₃N₄ oder Polysilizium zu bilden. Selektiv zu SiO₂ wird dann Si₃N₄ oder Polysilizium unterätzt. Schließlich wird in einem isotropen Ätzschritt die an der Oberfläche des Substrats befindliche Si₂O-Schicht geätzt. Bei einem hinreichend großen Unterschied in den Dicken zwischen den beiden SiO₂-Schichten verändert sich auch in diesem Verfahren der Querschnitt der Öffnung innerhalb der oberen Schicht praktisch nicht.

Es liegt im Rahmen der Erfindung, daß Verfahren zur Herstellung eines Bipolartransistors anzuwenden. Dabei wird das einkristalline Gebiet als Kollektor verwendet.

Es liegt weiterhin im Rahmen der Erfindung, das Verfahren zur Herstellung eines MOS-Transistors zu verwenden. Dabei werden Source- und Drain-Gebiet in dem einkristallinem Gebiet herge_{stellt.}

Weitere Ausgestaltungen der Erfindung gehen aus den übrigen Ansprüchen hervor.

Im folgenden wird die Erfindung anhand der Figuren und der Ausführungsbeispiele näher erläutert.
- Fig. 1: zeigt eine aus zwei Schichten zusammengesetzte maskierende Schicht mit einer Öffnung, innerhalb der nach dem erfindungsgemäßen Verfahren ein einkristallines Gebiet hergestellt wurde.
- Fig. 2: zeigt ein durch selektive Epitaxie nach dem Stand der Technik hergestelltes einkristallines Gebiet.
- Fig. 3: zeigt eine maskierende Schicht mit einer Öffnung, deren Seitenwand einen stufenförmigen Verlauf im Querschnitt senkrecht zur Substratoberfläche aufweist.
- Fig. 4 bis 7: zeigt die Herstellung einer Öffnung in einer maskierenden Schicht, die aus drei Schichten zusammengesetzt ist.
- Fig. 8 bis 11: zeigt eine andere Ausführungsform zur Herstellung einer Öffnung in einer maskierenden Schicht, die aus drei Schichten zusammengesetzt ist.
- Fig. 12: zeigt einen Bipolartransistor mit einem nach dem erfindungsgemäßen Verfahren hergestellten Kollektor.
- Fig. 13: zeigt einen MOS-Transistor mit einem nach dem erfindungsgemäßen Verfahren hergestellten einkristallinen Gebiet.
- Fig. 14: zeigt einen Gummelplot eines 560 K Multiemitter- und Multikollektor-Arrays mit selektiv abgeschiedenem Kollektor.

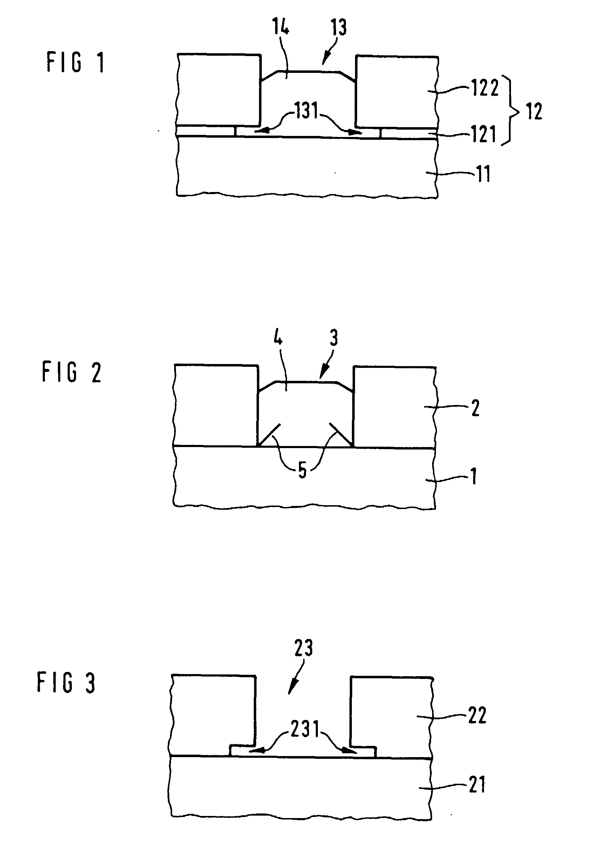

Auf ein Substrat 11 wird eine maskierende Schicht 12 mit einer Öffnung 13 erzeugt (s. Fig. 1). Das Substrat 11 besteht z. B. aus einkristallinem Silizium. Die maskierende Schicht 12 wird z. B. durch Aufbringen einer Si₃N₄-Schicht 121 auf die Oberfläche des Substrats 11 und durch anschließendes Aufbringen einer SiO₂-Schicht 122 auf die Oberfläche der Si₃N₄-Schicht 121 erzeugt. Die Si₃N₄-Schicht 121 wird in einer Dicke von z. B. 10 bis 50 nm, die SiO₂-Schicht 122 in einer Dicke von z. B. 400 nm aufgebracht. Zur Bildung der Öffnung 13 wird die SiO₂-Schicht 122 zunächst anisotrop strukturiert. Anschließend wird die Si₃N₄-Schicht 121 selektiv zu SiO₂ und zu Si isotrop geätzt. Dazu wird z. B. Phosphorsäure verwendet. Dabei wird unter die SiO₂-Schicht 122 eine Unterätzung 131 vorgenommen. Durch die Unterätzung 131 weist die Öffnung 13 eine Seitenwand mit einem stufenförmigen Verlauf auf.

An der innerhalb der Öffnung 13 freigelegten Oberfläche des Substrats 11 wird durch selektive Epitaxie ein einkristallines Gebiet 14 gebildet, das in der Hohe bis in den Bereich der SiO₂-Schicht 122 reicht. Da sich Seitenwanddefekte ausgehend von den Grenzflächen zwischen der Si₃N₄-Schicht 121 und der Oberfläche des Substrats 11 bilden und unter einem Winkel von etwa 55° hochwachsen, wird das Wachstum der Seitenwanddefekte durch den von der SiO₂-Schicht 122 gebildeten Überhang über die Unterätzungen 131 unterbrochen. In dem von der SiO₂-Schicht 122 begrenzten Teil der Öffnung 13 wächst das einkristalline Gebiet 14 im wesentlichen frei von Seitenwanddefekten auf.

Bei der selektiven Epitaxie nach dem Stand der Technik wird auf ein Substrat 1 eine maskierende Schicht 2 aufgebracht, die eine Öffnung 3 aufweist. Innerhalb der Öffnung 3 ist die Oberfläche des Substrats 1 freigelegt. Ausgehend von der freiliegenden Oberfläche des Substrats 1 wird in der Öffnung 3 ein einkristallines Gebiet 4 durch selektive Epitaxie aufgewachsen. Dabei wachsen Seitenwanddefekte 5 ausgehend von der Grenzfläche zwischen maskierender Schicht 2 aus dielektrischem Material und Substrat 11 hoch. Diese Seitenwanddefekte 5 schränken die Einsatzmöglichkeiten des einkristallinen Gebietes 4 ein (s. Fig. 2).

Auf die Oberfläche eines Substrats 21 aus z. B. einkristallinem Silizium wird eine maskierende Schicht 22 mit einer Öffnung 23 aufgebracht. Die maskierende Schicht 22 besteht z. B. aus SiO₂. Die Öffnung 23 weist im Bereich der Oberfläche der maskierenden Schicht 22 einen Querschnitt auf, der kleiner ist als der Querschnitt im Bereich der Oberfläche des Substrats 21. Im Bereich der Oberfläche des Substrats 21 ist der Querschnitt der Öffnung 23 um Unterätzungen 231 vergrößert, die zu einem stufenförmigen Verlauf der Seitenwand der Öffnung 23 führen. Die Unterätzungen 231 werden in Wasserstoffatmosphäre bei Temperaturen oberhalb 900 °C durch die Reaktion Si + SiO₂ → 2SiO ↑ gebildet. Die Unterätzungen 231 werden in einer solchen Tiefe gebildet, daß beim Aufwachsen eines einkristallinen Gebietes (nicht dargestellt) durch selektive Epitaxie in der Öffnung 23 an der Grenzfläche der maskierenden Schicht 22 und der Substratoberfläche 21 entstehende Seitenwanddefekte in ihrem Wachstum durch den Überhang über die Unterätzungen 231 unterbrochen werden (s. Fig. 3).

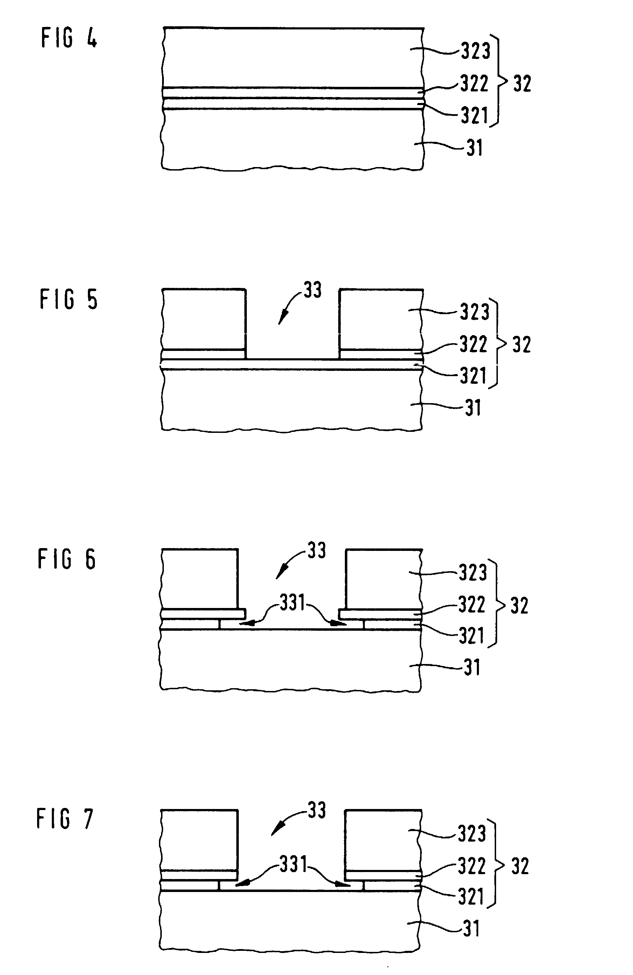

Auf ein Substrat 31, das z. B. aus einkristallinem Silizium besteht, wird eine erste Hilfsschicht 321 aus z. B. SiO₂ aufgebracht. Auf die erste Hilfsschicht 321 wird eine zweite Hilfsschicht 322 aus z. B. Si₃N₄ aufgebracht. Auf die zweite Hilfsschicht 322 wird eine Hauptschicht 323 aus z. B. SiO₂ aufgebracht (s. Fig. 4). Die erste Hilfsschicht 321 wird z. B. in einer Dicke von 30 nm, die zweite Hilfsschicht 322 wird z. B. in einer Dicke von 30 nm und die Hauptschicht 323 wird z. B. in einer Dicke von 400 nm abgeschieden. Die erste Hilfsschicht 321, die zweite Hilfsschicht 322 und die Hauptschicht 323 bilden gemeinsam eine maskierende Schicht 32.

Zur Bildung einer Öffnung 33 in der maskierenden Schicht 32 (s. Fig. 5) wird zunächst in einem anisotropen Ätzprozeß die Hauptschicht 323 und die zweite Hilfsschicht 322 strukturiert. Dazu wird z. B. folgendes Ätzverfahren angewendet: Plasmaätzen in CF₄.

Anschließend erfolgt eine isotrope Ätzung der ersten Hilfsschicht 321, bei der eine Unterätzung 331 unter die zweite Hilfsschicht 322 gebildet wird (s. Fig. 6).

Als Ätzverfahren ist dabei z. B. Ätzen in HF geeignet. Sowohl die erste Hilfsschicht 321 als auch die Hauptschicht 323 bestehen aus SiO₂. Zur Realisierung der Unterätzung 331 muß daher die Ätzrate in lateraler Richtung in der ersten Hilfsschicht 321 großer sein als in der Hauptschicht 323. Wenn die erste Hilfsschicht 321 viel dünner als die Hauptschicht 323 ist, ist dieses aus geometrischen Gründen gewährleistet. Der Ätzabtrag an den Seitenwänden der Öffnung 33 im Bereich der Hauptschicht 323 ist geringer als die Tiefe der Unterätzungen 331.

Durch eine zu SiO₂ selektive Ätzung des Si₃N₄ der zweiten Hilfsschicht 322 wird die zweite Hilfsschicht 322 an der Kanten zur Öffnung 33 der Hauptschicht 323 angepaßt (s. Fig. 7). Werden die erste Hilfsschicht 321 und die Hauptschicht 323 in unterschiedlichen Herstellverfahren gebildet, so daß sie zueinander selektiv ätzbar sind, wird die Unterätzung 331 in einem zur zweiten Hilfsschicht und zur Hauptschicht 323 selektiven Ätzverfahren gebildet. Durch Herstellung der ersten Hilfsschicht 321 aus Plasmaoxid und der Hauptschicht 323 aus BPSG ist eine selektive Ätzung der ersten Hilfsschicht 321 mit gepufferter NH₄F möglich.

Für den Fall, daß die Hauptschicht 323 sehr viel dicker ist als die erste Hilfsschicht 321, d. h. mindestens um einen Faktor 10, wird bei der Bildung der Unterätzungen 331 die Hauptschicht 323 praktisch nicht angegriffen. In diesem Fall kann die zweite selektive Ätzung des Siliziumnitrids unterbleiben.

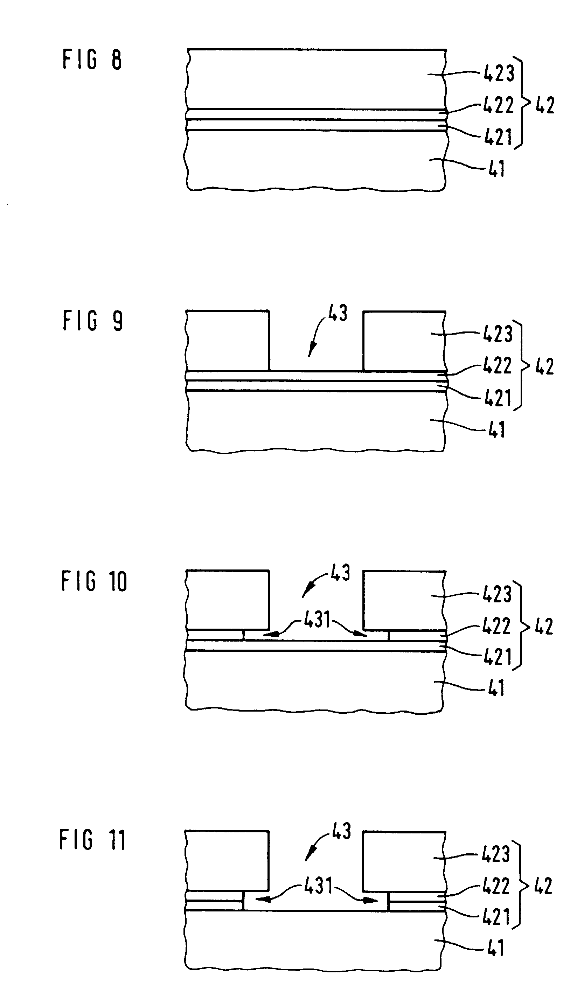

Auf ein Substrat 41 aus z. B. einkristallinem Silizium wird eine erste Hilfsschicht 421 aufgebracht. Auf die erste Hilfsschicht 421 wird eine zweite Hilfsschicht 422 aufgebracht. Auf die zweite Hilfsschicht 422 wird eine Hauptschicht 423 aufgebracht. Die erste Hilfsschicht 421 wird z. B. aus SiO₂ in einer Dicke von z. B. 30 nm gebildet. Die zweite Hilfsschicht wird z. B. aus Polysilizium in einer Dicke von z. B. 30 nm aufgebracht. Die Hauptschicht 423 wird z. B. aus SiO₂ in einer Dicke von z. B. 400 nm aufgebracht. Die erste Hilfsschicht 421, die zweite Hilfsschicht 422 und die Hauptschicht 423 bilden gemeinsam eine maskierende Schicht 42 (s. Fig. 8).

Zur Bildung einer Öffnung 43 in der maskierenden Schicht 42 wird zunächst die Hauptschicht anisotrop geätzt. Diese Ätzung erfolgt selektiv zur zweiten Hilfsschicht 422. Dazu ist z. B. anisotropes Plasmaätzen geeignet. Anschließend wird die zweite Hilfsschicht 422 isotrop und selektiv geätzt (s. Fig. 10). Dabei entstehen Unterätzungen 431 unter die Hauptschicht 423. Als Ätzverfahren ist z. B. im Falle von Polysilizium Cholin geeignet. Die Unterätzung 431 reicht z. B. 60 nm hinter die Kante der Hauptschicht 423 zurück.

Als zweite Hilfsschicht kann auch Siliziumnitrid verwendet werden, dann erfolgt die isotrope Ätzung mit Phosphorsäure.

Anschließend wird die erste Hilfsschicht 421 selektiv zur zweiten Hilfsschicht 422 und zur Oberfläche des Substrats 41 isotrop geätzt. Als Ätzmittel ist z. B. 5 %ige HF geeignet. Da die erste Hilfsschicht 421 sehr viel dünner als die Hauptschicht 423 ist, wird die Hauptschicht 423, die aus demselben Material wie die erste Hilfsschicht 421, SiO₂, besteht, bei dieser isotropen Ätzung praktisch nicht angegriffen. Bei der isotropen Ätzung wird der freiliegende Teil der ersten Hilfsschicht 421 entfernt. Dadurch vergrößert sich die Unterätzung 431 um die Dicke der ersten Hilfsschicht 421. In der Öffnung 43 wird anschließend (nicht dargestellt) das einkristalline Gebiet durch selektive Epitaxie aufgewachsen.

In den anhand von Fig. 1, Fig. 3 bis 11 beschriebenen Ausführungsbeispielen kann die maskierende Schicht mit der Öffnung und das einkristalline Gebiet auch auf einem Substrat aufgewachsen werden, das nur im Bereich der Öffnung einkristallines Silizium umfaßt. Insbesondere kann als Substrat ein SOI-Substrat verwendet werden, das eine dünne einkristalline Siliziumschicht an der Oberfläche einer isolierenden Schicht umfaßt.

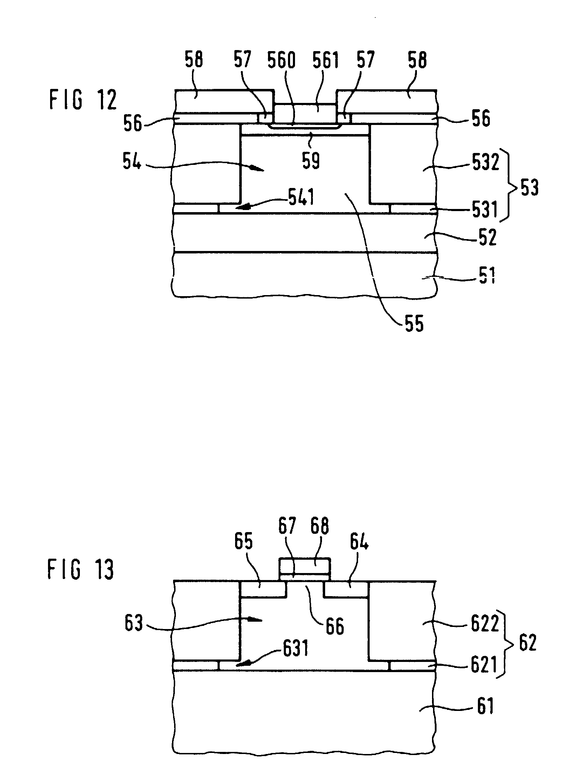

Anhand von Fig. 12 wird im folgenden geschildert, wie das erfindungsgemäße Verfahren zur Herstellung eines Bipolartransistors eingesetzt werden kann. Auf ein Substrat 51 aus z. B. einkristallinem Silizium wird ganzflächig eine n⁺-dotierte Schicht 52 z. B. durch Implantation oder epitaktisch erzeugt. Auf die Oberfläche der n⁺-dotierten Schicht 52 wird eine maskierende Schicht 53 aufgebracht, die eine z. B. 10 bis 50 nm dicke Si₃N₄-Schicht 531 und eine z. B. 500 nm dicke SiO₂-Schicht 532 umfaßt. Die maskierende Schicht 53 kann auch entsprechend den anhand der Figuren 4 bis 11 ausgeführten Ausführungsbeispielen zusammengesetzt sein. In der maskierenden Schicht 53 wird eine Öffnung 54 nach einem der in den voran beschriebenen Ausführungsbeispielen dargestellten Verfahren gebildet. Die Öffnung 54 umfaßt Unterätzungen 541, die unter die SiO₂-Schicht 532 reichen.

In der Öffnung 54 wird durch selektive Epitaxie ein Kollektor 55 abgeschieden. Die selektive Epitaxie erfolgt z. B. bei Temperaturen zwischen 500 °C und 1000 °C in einer Si-HCl-H-Atmosphäre. Vorzugsweise wird die selektive Epitaxie bei 855 °C, 60 slm H₂, 220 sccm Dichlorsilan, 10 Torr durchgeführt.

Das einkristalline Gebiet, das zur Bildung des Kollektors 55 mit einer entsprechenden Dotierung versehen wird, wird so aufgewachsen, daß nach Entfernen der bei der selektiven Epitaxie an der Oberfläche entstehenden Facetten die SiO₂-Schicht 532 und das einkristalline Gebiet eine ebene Oberfläche bilden. An der Oberfläche der hergestellten Struktur wird ein Basisanschluß 56 aus p-dotiertem Polysilizium gebildet. Der Basisanschluß 56 ist im wesentlichen an der Oberfläche der SiO₂-Schicht 532 angeordnet, er überragt diese und reicht in den Bereich des einkristallinen Gebietes, das die Öffnung 54 auffüllt, hinein. An seitlichen Flanken des Basisanschlusses 56 werden Si₃N₄-Spacer 57 gebildet. Die Oberfläche der Si₃N₄-Spacer 57 und des Basisanschlusses 56 wird mit einer SiO₂- Struktur 58 bedeckt.

In einem Ätzschritt, der selektiv zu Si₃N₄ und SiO₂ Silizium angreift, wird die oberste Schicht des einkristallinen Gebietes, die oberhalb des Kollektors 55 angeordnet ist, entfernt. Dabei entstehen Unterätzungen unter die Si₃N₄-Spacer 57 und den Basisanschluß 56.

Auf die freigelegte Oberfläche des Kollektors 55 wird durch selektive Epitaxie eine p-dotierte Basis 59 aufgewachsen. Ein n-dotierter Emitter 560 wird an der Oberfläche der Basis 59 durch Ausdiffusion aus einem Emitteranschluß 561, der aus entsprechend dotiertem Polysilizium besteht, gebildet.

Anhand von Fig. 13 wird im folgenden die Herstellung eines MOS-Transistors unter Verwendung des erfindungsgemäßen Verfahrens erläutert. Auf einem Substrat 61 aus z. B. einkristallinem Silizium wird eine maskierende Schicht 62 aufgebracht. Die maskierende Schicht 62 umfaßt an der Oberfläche des Substrats 61 eine Si₃N₄-Schicht 621 und an der Oberfläche der Si₃N₄-Schicht 621 eine SiO₂-Schicht 622. Die maskierende Schicht 62 kann auch entsprechend den anhand von Fig. .4 bis 11 erläuterten Ausführungsbeispielen aus mehr als zwei Schichten aufgebaut sein.

In der maskierenden Schicht wird eine Öffnung 63 mit einem stufenförmigen Seitenwandprofil gebildet. Die stufenförmige Seitenwand der Öffnung 63 wird durch Unterätzungen 631 unter die SiO₂-Schicht 622 realisiert.

Die Öffnung 63 wird durch selektive Epitaxie aufgefüllt mit einkristallinem Silizium. Die selektive Epitaxie wird z. B. bei Temperaturen zwischen 500 °C und 1000 °C in einer Si-HCl-H-Atmosphäre durchgeführt. In dem die Öffnung 63 auf füllenden einkristallinen Gebiet werden z. B. durch Implantation ein Source-Gebiet 64, ein Drain-Gebiet 65 und ein Kanal-Gebiet 66 gebildet. Source- und Drain-Gebiete 64, 65 werden dabei vom entgegengesetzten Leitfähigkeitstyp wie das einkristalline Gebiet dotiert. An der Oberfläche des Kanalgebietes 66 wird ein Gatedielektrikum 67 und an der Oberfläche des Gatedielektrikums eine Gateelektrode 68 gebildet.

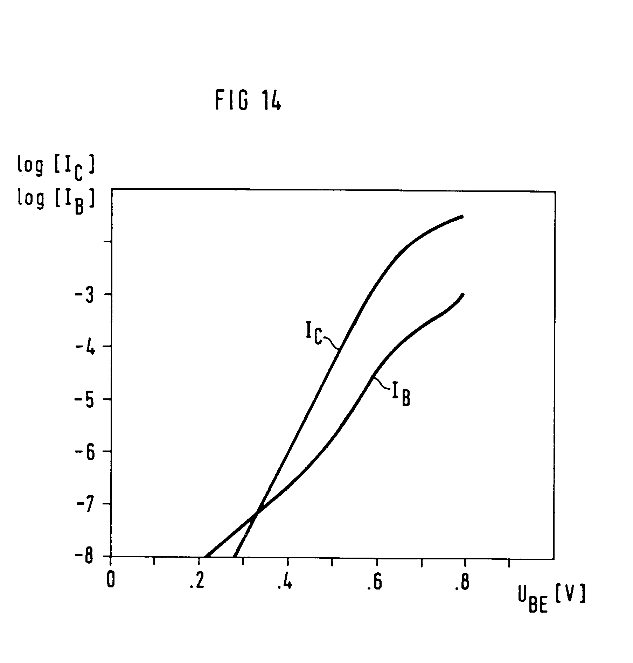

Fig. 14 zeigt einen Gummelplot eines 560 K Multiemitter- und Multikollektor-Arrays. Das Array umfaßt 5,6 x 10⁵ Bipolartransistoren, die jeweils einen nach dem erfindungsgemäßen Verfahren selektiv abgeschiedenen Kollektor aufweisen. Die aktive Fläche jedes Bipolartransistors beträgt 0,4 x 3 µm². Die einzelnen Bipolartransistoren sind voneinander jeweils durch die maskierende Schicht isoliert. Die aufsummierte Seitenwandlänge in dem Array beträgt 6,8 x 56 cm. Dem Gummelplot ist zu entnehmen, daß diese Seitenwandlänge praktisch frei von Seitenwanddefekten ist.

## Patentansprüche

1. Verfahren zur Herstellung eines seitlich begrenzten, einkristallinen Gebietes mittels selektiver Epitaxie,
- bei dem auf der Oberfläche eines Substrats (21), das mindestens im Bereich der Oberfläche einkristallines Halbleitermaterial umfaßt, eine maskierende Schicht (22) erzeugt wird, die im wesentlichen aus dielektrischem Material besteht,
- bei dem in der maskierenden Schicht (22) eine Öffnung (23) erzeugt wird, in der die Oberfläche des Substrats (21) freigelegt wird, deren Querschnitt parallel zur Oberfläche des Substrats an der Oberfläche des Substrats denjenigen in einem oberen Teil der Öffnung (23) an der Oberfläche der maskierenden Schicht (22) seitlich überragt, deren Seitenwand im Bereich der Oberfläche der maskierenden Schicht (22) im wesentlichen senkrecht zur Oberfläche des Substrats (21) verläuft und deren Seitenwand im Querschnitt senkrecht zur Oberfläche des Substrats (22) einen stufenförmigen Verlauf aufweist,
- bei dem das einkristalline Gebiet durch selektive Epitaxie innerhalb der Öffnung (23) gebildet wird, das bis in den oberen Teil der Öffnung (23) reicht.

2. Verfahren nach Anspruch 1,
bei dem zur Bildung der Öffnung zunächst ein anisotropes Ätzverfahren angewendet wird, mit dem der Querschnitt der Öffnung (23) parallel zur Oberfläche im Bereich der Oberfläche der maskierenden Schicht (22) definiert wird und
bei dem anschließend durch isotropes Ätzen, das die maskierende Schicht verstärkt im Bereich der Grenzfläche zum Substrat (21) angreift, der Querschnitt der Öffnung (23) parallel zur Oberfläche an der Oberfläche des Substrats (21) durch Unterätzungen (231) vergrößert wird.

3. Verfahren nach Anspruch 2,
bei dem die Oberfläche des Substrats (21) einkristallines Silizium umfaßt,
bei dem die maskierende Schicht (22) aus SiO₂ gebildet wird und
bei dem die isotrope Ätzung bei einer Temperatur oberhalb 900 °C in Wasserstoffatmosphäre durch die Reaktion Si + SiO₂ → 2SiO ↑ erfolgt.

4. Verfahren nach Anspruch 2,
- bei dem zur Bildung der maskierenden Schicht (12) auf die Oberfläche des Substrats (11) eine erste Schicht (121) und auf die Oberfläche der ersten Schicht (121) eine zweite Schicht (122) aufgebracht wird,
- bei dem in dem anisotropen Ätzverfahren die zweite Schicht (122) geätzt wird,
- bei dem durch isotropes Ätzen selektiv zur zweiten Schicht (122) die erste Schicht (121) geätzt wird, wobei die Oberfläche des Substrats (11) freigelegt wird und die erste Schicht (121) unter die zweite Schicht (122) zurückgeätzt wird, so daß eine Unterätzung (131) unter die zweite Schicht (122) entsteht, in der die Oberfläche des Substrats (11) freiliegt und die den Querschnitt der Öffnung (13) an der Oberfläche des Substrats (11) gegenüber dem Querschnitt der Öffnung (13) im Bereich der zweiten Schicht (122) vergrößert.

5. Verfahren nach Anspruch 4, bei dem die Oberfläche des Substrats (11) einkristallines Silizium umfaßt, bei dem die erste Schicht (121) aus Si₃N₄ und die zweite Schicht (122) aus SiO₂ gebildet werden.

6. Verfahren nach Anspruch 2,
- bei dem zur Bildung der maskierenden Schicht (32) auf der Oberfläche des Substrats (31) eine erste Hilfsschicht (321), auf der Oberfläche der ersten Hilfsschicht (321) eine zweite Hilfsschicht (322) und auf der Oberfläche der zweiten Hilfsschicht (322) eine Hauptschicht (323) erzeugt wird,
- bei dem in dem anisotropen Ätzverfahren die Hauptschicht (323) geätzt wird,
- bei dem durch isotropes Ätzen selektiv zur Hauptschicht (323) die zweite Hilfsschicht (322) geätzt wird, wobei die Oberfläche der ersten Hilfsschicht (321) freigelegt wird,
- bei dem durch isotropes Ätzen selektiv zur zweiten Hilfsschicht (322) die erste Hilfsschicht (321) geätzt wird, wobei die Oberfläche des Substrats (31) freigelegt wird und die erste Hilfsschicht (321) unter die zweite Hilfsschicht (322) zurückgeätzt wird, so daß eine Unterätzung unter die zweite Hilfsschicht (322) entsteht, in der die Oberfläche des Substrats (31) frei liegt und die den Querschnitt der Öffnung (33) im Bereich der Oberfläche des Substrats (31) um die Unterätzung (331) vergrößert.

7. Verfahren nach Anspruch 6, bei dem die erste Hilfsschicht (321) aus SiO₂, die zweite Hilfsschicht (322) aus Si₃N₄ oder Polysilizium und die Hauptschicht (323) aus SiO₂ gebildet werden.

8. Verfahren nach Anspruch 7, bei dem zur Bildung der Unterätzung (331) unter die zweite Hilfsschicht (322) die erste Hilfsschicht (321) selektiv zur Hauptschicht (323) geätzt wird.

9. Verfahren nach Anspruch 7, bei dem die erste Hilfsschicht (321) um so viel dünner als die Hauptschicht (323) ist, daß in dem Ätzschritt zur Bildung der Unterätzung (331) unter die zweite Hilfsschicht (322) der Ätzangriff aufgrund der Geometrie hauptsächlich die erste Hilfsschicht (321) entfernt.

10. Verfahren nach Anspruch 2,
- bei dem zur Bildung der maskierenden Schicht (42) auf der Oberfläche des Substrats (41) eine erste Hilfsschicht (421), auf der Oberfläche der ersten Hilfsschicht (421) eine zweite Hilfsschicht (422) und auf der Oberfläche der zweiten Hilfsschicht (422) eine Hauptschicht (423) erzeugt wird,
- bei dem in dem anisotropen Ätzverfahren die Hauptschicht (423) geätzt wird,
- bei dem durch isotropes Ätzen selektiv zur Hauptschicht (423) und zur ersten Hilfsschicht (421) die zweite Hilfsschicht (422) geätzt wird, wobei die Oberfläche der ersten Hilfsschicht (421) freigelegt wird und die zweite Hilfsschicht (422) unter die Hauptschicht (423) zurückgeätzt wird, so daß eine Unterätzung (431) unter die Hauptschicht (423) entsteht, in der die Oberfläche der ersten Hilfsschicht (421) freiliegt und die den Querschnitt der Öffnung (43) vergrößert,
- bei dem durch isotropes Ätzen selektiv zur zweiten Hilfsschicht (422) freiliegende Teile der ersten Hilfsschicht (421) entfernt werden.

11. Verfahren nach Anspruch 10, bei dem die Hauptschicht (423) und die erste Hilfsschicht (421) jeweils aus SiO₂ gebildet werden, wobei die erste Hilfsschicht (421) dünner als die Hauptschicht (423) ist, und bei dem die zweite Hilfsschicht (422) aus Si₃N₄ oder Polysilizium gebildet wird.

12. Verfahren nach einem der Ansprüche 1 bis 11, bei dem die selektive Epitaxie im Temperaturbereich zwischen 500 °C und 1000 °C in einer Si-HCl-H-Atmosphäre erfolgt.

13. Verfahren zur Herstellung eines Bipolartransistors nach einem der Ansprüche 1 bis 12,
- bei dem in dem Substrat (51) unterhalb des einkristallinen Gebietes ein Kollektoranschlußgebiet (52) gebildet wird,
- bei dem das einkristalline Gebiet so dotiert wird, daß es einen Kollektor (55) bildet,
- bei dem an der Oberfläche des einkristallinen Gebiets eine Basis (59) und an der Oberfläche der Basis (59) ein Emitter (560) gebildet wird.

14. Verfahren nach Anspruch 13
- bei dem das einkristalline Gebiet in der Höhe mit der maskierenden Schicht (53) abschließt,
- bei dem an der Oberfläche der maskierenden Schicht (53) ein Basisanschluß (56) aus dotiertem polykristallinem Silizium gebildet wird, der bis an die Oberfläche des einkristallinen Gebietes reicht und der das einkristalline Gebiet ringförmig umgibt,
- bei dem die Basis (59) an der Oberfläche des einkristallinen Gebietes gebildet wird,
- bei dem der Basisanschluß (56) mit einer isolierenden Schicht (58) und an den dem einkristallinen Gebiet zugewandten Seiten mit isolierenden Flankenbedeckungen (57) versehen wird,
- bei dem an der Oberfläche der Basis (59) durch Ausdiffusion aus einer entsprechend dotierten Polysiliziumschicht (561) der Emitter (560) gebildet wird.

15. Verfahren nach Anspruch 14,
- bei dem zur Bildung der Basis (59) nach der Herstellung des Basisanschlusses (56) der isolierenden Schicht und der isolierenden Flankenbedeckungen (57) das einkristalline Gebiet in einer Tiefe entsprechend der Basisweite abgeätzt wird, wobei Unterätzungen unter den Basisanschluß (56) gebildet werden,
- bei dem die Basis (59) durch selektive Epitaxie auf der freigelegten Oberfläche des Kollektors (55) gebildet wird.

16. Verfahren zur Herstellung eines MOS-Transistors nach einem der Ansprüche 1 bis 12,
- bei dem das einkristalline Gebiet in der Höhe mit der maskierenden Schicht (63) abschließt,
- bei dem in dem einkristallinen Gebiet Source (64), Drain (65) und Kanalgebiet (66) gebildet werden,
- bei dem mindestens an der Oberfläche des Kanalgebietes (66) ein Gatedielektrikum (67) und an der Oberfläche des Gatedielektrikums (67) eine Gateelektrode (68) gebildet wird.

## Claims

1. Method for the production of a laterally bounded monocrystalline region by means of selective epitaxy,
- in which a masking layer (22), which essentially consists of dielectric material, is produced on the surface of a substrate (21) which comprises monocrystalline semiconductor material at least in the region of the surface,
- in which an open (23), in which the surface of the substrate (21) is exposed, is produced in the masking layer (22), the cross-section of which opening (23) parallel to the surface of the substrate, at the surface of the substrate, extending laterally beyond the cross-section in an upper part of the opening (23), at the surface of the masking layer (22), whose side wall extends essentially perpendicular to the surface of the substrate (21) in the region of the surface of the masking layer (22), and whose side wall has a stepped profile in the cross-section perpendicular to the surface of the substrate (22),
- in which the monocrystalline region, which extends into the upper part of the opening (23), is formed by selective epitaxy inside the opening (23).

2. Method according to Claim 1, in which, for forming the opening, use is firstly made of an anisotropic etching method in which the cross-section of the opening (22) parallel to the surface is defined in the region of the surface of the masking layer (22), and in which, by isotropic etching which attacks the masking layer more strongly in the region of the interface with the substrate (21), the cross-section of the opening (23) parallel to the surface of the opening is subsequently increased at the surface of the substrate (21) by undercut etching (231).

3. Method according to Claim 2, in which the surface of the substrate (21) comprises monocrystalline silicon, in which the masking layer (22) is formed from SiO₂, and in which the isotropic etching takes place at a temperature in excess of 900°C in a hydrogen atmosphere by the reaction Si + SiO₂ → 2SiO ↑.

4. Method according to Claim 2,
- in which, for forming the masking layer (12), a first layer (121) is applied to the surface of the substrate (11) and a second layer (122) is applied to the surface of the first layer (121),
- in which the second layer (122) is etched in the anisotropic etching process,
- in which the first layer (121) is etched by isotropic etching selectively with respect to the second layer (122), the surface of the substrate (11) being exposed and the first layer (121) being etched back under the second layer (122) so as to produce, under the second layer (122), an etched undercut (121) in which the surface of the substrate (11) is exposed and which increases the cross-section of the opening (13) at the surface of the substrate (11) in comparison with the cross-section of the opening (13) in the region of the second layer (122).

5. Method according to Claim 4, in which the surface of the substrate (11) comprises monocrystalline silicon, and in which the first layer (121) is formed from Si₃N₄ and the second layer (122) is formed from SiO₂.

6. Method according to Claim 2,
- in which, for forming the masking layer (32), a first auxiliary layer (321) is produced on the surface of the substrate (31), a second auxiliary layer (322) is produced on the surface of the first auxiliary layer (321) and a main layer (323) is produced on the surface of the second auxiliary layer (322),
- in which the main layer (323) is etched in the anisotropic etching process,
- in which the second auxiliary layer (322) is etched by isotropic etching selectively with respect to the main layer (323), the surface of the first auxiliary layer (321) being exposed,
- in which the first auxiliary layer (321) is etched by isotropic etching selectively with respect to the second auxiliary layer (322), the surface of the substrate (31) being exposed and the first auxiliary layer (321) being etched back under the second auxiliary layer (322) so as to produce, under the second auxiliary layer (322), an etched undercut in which the surface of the substrate (31) is exposed and which increases the cross-section of the opening (33) in the region of the surface of the substrate (31) around the etched undercut (331).

7. Method according to Claim 6, in which the first auxiliary layer (321) is formed from SiO₂, the second auxiliary layer (322) is formed from Si₃N₄ or polysilicon and the main layer (323) is formed from SiO₂.

8. Method according to Claim 7, in which, for forming the etched undercut (331) under the second auxiliary layer (322), the first auxiliary layer (321) is etched selectively with respect to the main layer (323).

9. Method according to Claim 7, in which the first auxiliary layer (321) is so much thinner than the main layer (323) that, in the etching step for forming the etched undercut (331) under the second auxiliary layer (322), the etching attack primarily removes the first auxiliary layer (321) on account of the geometry.

10. Method according to Claim 2
- in which, for forming the masking layer (42), a first auxiliary layer (421) is produced on the surface of the substrate (41), a second auxiliary layer (422) is produced on the surface of the first auxiliary layer (421) and a main layer (423) is produced on the surface of the second auxiliary layer (422),
- in which the main layer (423) is etched in the anisotropic etching process,
- in which the second auxiliary layer (422) is etched by isotropic etching selectively with respect to the main layer (423) and the first auxiliary layer (421), the surface of the first auxiliary layer (421) being exposed, and the second auxiliary layer (422) being etched under the main layer (423) so as to produce, under the main layer (423), an etched undercut (431) in which the surface of the first auxiliary layer (421) is exposed and which increases the cross-section of the opening (43),
- in which exposed parts of the second auxiliary layer (422) are removed by isotropic etching selectively with respect to the second auxiliary layer (422).

11. Method according to Claim 10, in which the main layer (423) and the first auxiliary layer (421) are each formed from SiO₂, the first auxiliary layer (421) being thinner than the main layer (423), and in which the second auxiliary layer (422) is formed from Si₃N₄ or polysilicon.

12. Method according to one of Claims 1 to 11, in which the selective epitaxy takes place in the temperature range between 500°C and 1000°C in an Si-HCl-H atmosphere.

13. Method for producing a bipolar transistor according to one of Claims 1 to 12
- in which a collector terminal region (52) is formed in the substrate (51) below the monocrystalline region,
- in which the monocrystalline region is doped in such a way that it forms a collector (55),
- in which a base (59) is formed at the surface of the monocrystalline region, and an emitter (560) is formed at the surface of the base (59).

14. Method according to Claim 13
- in which the monocrystalline region ends level with the masking layer (53),
- in which a base terminal (56) of doped polycrystalline silicon, which extends as far as the surface of the monocrystalline region and annularly surrounds the monocrystalline region, is formed at the surface of the masking layer (53),
- in which the base (59) is formed at the surface of the monocrystalline region,
- in which the base terminal (56) is provided with an insulating layer (58) and, on the side facing the monocrystalline region, with insulating flank coverings (57),
- in which the emitter (560) is formed at the surface of the base (59) by diffusion out of an appropriately doped polysilicon layer (561).

15. Method according to Claim 14,
- in which, for forming the base (59), after the production of the base terminal (56), of the insulating layer and of the insulating flank coverings (57), the monocrystalline region is etched away at a depth corresponding to the base width, etched undercuts being formed under the base terminal (56),
- in which the base (59) is formed by selective epitaxy on the exposed surface of the collector (55).

16. Method for the production of an MOS transistor according to one of Claims 1 to 12,
- in which the monocrystalline region ends level with the masking layer (63),
- in which a source (64), drain (65) and channel region (66) are formed in the monocrystalline region,
- in which a gate dielectric (67) is formed at least at the surface of the channel region (66), and a gate electrode (68) is formed at the surface of the gate dielectric (67) .

## Revendications

1. Procédé pour la formation d'un domaine monocristallin délimité latéralement, au moyen d'une épitaxie sélective,
- dans lequel on forme, sur la surface d'un substrat (21) qui comprend, au moins dans la zone de sa surface, une matière monocristalline à semiconducteur, une couche de masquage (22) qui est constituée essentiellement d'une matière diélectrique,
- dans lequel, dans la couche de masquage (22), on pratique une ouverture (23), dans laquelle la surface du substrat (21) est mise à nu, dont la section transversale parallèlement à la surface du substrat, sur la surface du substrat, fait saillie latéralement par rapport à celle présente dans la partie supérieure de l'ouverture (23) à la surface de la couche de masquage (22), dont la paroi latérale dans la zone de la surface de la couche de masquage (22) s'étend essentiellement perpendiculairement à la surface du substrat (21) et dont la paroi latérale présente, en coupe transversale, perpendiculairement à la surface du substrat (21), une allure à gradin,
- dans lequel on forme un domaine monocristallin par épitaxie sélective à l'intérieur de l'ouverture (23), qui s'étend jusque dans la partie supérieure de l'ouverture (23).

2. Procédé selon la revendication 1,
dans lequel, pour la formation de l'ouverture, on applique d'abord un procédé de gravure anisotrope avec lequel on définit la section transversale de l'ouverture (23) parallèlement à la surface dans la zone de la surface de la couche de masquage (22) et dans lequel, par la suite, via une gravure isotrope qui attaque la couche de masquage de manière renforcée dans la zone de l'interface par rapport au substrat (21), on agrandit la section transversale de l'ouverture (23) parallèlement à la surface, sur la surface du substrat (21), via des gravures sous-jacentes (231).

3. Procédé selon la revendication 2,
dans lequel la surface du substrat (21) comprend du silicium monocristallin, dans lequel la couche de masquage (22) est réalisée à partir de SiO₂, et dans lequel la gravure isotrope a lieu à une température supérieure à 900°C dans une atmosphère d'hydrogène, conformément à la réaction Si + SiO₂ → 2SiO ↑.

4. Procédé selon la revendication 2,
- dans lequel, pour former la couche de masquage (12), on applique, sur la surface du substrat (11), une première couche (121) et, sur la surface de la première couche (121), une deuxième couche (122),
- dans lequel, dans le procédé de gravure anisotrope, on grave la deuxième couche (122),
- dans lequel, par gravure isotrope, on grave la première couche (121) de manière sélective par rapport à la deuxième couche (122) en mettant à nu la surface du substrat (11), et on soumet à une gravure sous-jacente la première couche (121) en dessous de la deuxième couche (122), si bien que l'on obtient une gravure sous-jacente (131) en dessous de la deuxième couche (122), dans laquelle la surface du substrat (11) est mise à nu et qui agrandit la section transversale de l'ouverture (13) à la surface du substrat (11) par rapport à la section transversale de l'ouverture (13) dans la zone de la deuxième couche (122).

5. Procédé selon la revendication 4,
dans lequel la surface du substrat (11) comprend du silicium monocristallin et dans lequel on forme la première couche (121) à partir de Si₃N₄ et la deuxième couche (122) à partir de SiO₂.

6. Procédé selon la revendication 2,
- dans lequel, pour former la couche de masquage (32), sur la surface du substrat (31), on forme une première couche auxiliaire (321); sur la surface de la première couche auxiliaire (321), on forme une deuxième couche auxiliaire (322); et, sur la surface de la deuxième couche auxiliaire (322), on forme une couche principale (323),
- dans lequel, dans le procédé de gravure anisotrope, on grave la couche principale (323),
- dans lequel, par gravure isotrope, on grave la deuxième couche auxiliaire (322) de manière sélective par rapport à la couche principale (323) en mettant à nu la surface de la première couche auxiliaire (321),
- dans lequel, par gravure isotrope, on grave la première couche auxiliaire (321) de manière sélective par rapport à la deuxième couche auxiliaire (322) en mettant à nu la surface du substrat (31), et on soumet à une gravure sous-jacente la première couche auxiliaire (321) en dessous de la deuxième couche auxiliaire (322), si bien que l'on obtient une gravure sous-jacente en dessous de la deuxième couche auxiliaire (322) dans laquelle la surface du substrat (31) est mise à nu et qui agrandit la section transversale de l'ouverture (33) dans la zone de la surface du substrat (31) autour de la gravure sous-jacente (331).

7. Procédé selon la revendication 6,
dans lequel on forme la première couche auxiliaire (321) à partir de SiO₂, la deuxième couche auxiliaire (322) à partir de Si₃N₄ ou de polysilicium et la couche principale (323) à partir de SiO₂.

8. Procédé selon la revendication 7,
dans lequel, pour former la gravure sous-jacente (331), on grave la première couche auxiliaire (321) en dessous de la deuxième couche auxiliaire (322) de manière sélective par rapport à la couche principale (323).

9. Procédé selon la revendication 7,
dans lequel la première couche auxiliaire (321) est à ce point plus mince que la couche principale (323) que, dans l'étape de gravure pour former la gravure sous-jacente (331) en dessous de la deuxième couche auxiliaire (322), l'attaque par gravure élimine, sur base de la géométrie, principalement la première couche auxiliaire (321).

10. Procédé selon la revendication 2,
- dans lequel, pour la formation de la couche de masquage (42), sur la surface du substrat (41), on forme une première couche auxiliaire (421); sur la surface de la première couche auxiliaire (421), on forme une deuxième couche auxiliaire (422); et, sur la surface de la deuxième couche auxiliaire (422), on forme une couche principale (423),
- dans lequel, dans le procédé de gravure anisotrope, on grave la couche principale (423),
- dans lequel, par gravure isotrope, on grave la deuxième couche auxiliaire (422) de manière sélective par rapport à la couche principale (423) et par rapport à la première couche auxiliaire (421), en mettant à nu la surface de la première couche auxiliaire (421), et on soumet à une gravure sous-jacente la deuxième couche auxiliaire (422) en dessous de la couche principale (423), si bien que l'on obtient une gravure sous-jacente (431) en dessous de la couche principale (423), dans laquelle la surface de la première couche auxiliaire (421) est mise à nu et qui agrandit la section transversale de l'ouverture (43),
- dans lequel, par gravure isotrope, on élimine de manière sélective par rapport à la deuxième couche auxiliaire (422) les parties mises à nu de la première couche auxiliaire (421).

11. Procédé selon la revendication 10,
dans lequel on forme la couche principale (423) et la première couche auxiliaire (421) respectivement à partir de SiO₂, la première couche auxiliaire (421) étant plus mince que la couche supérieure (423), et dans lequel on forme la deuxième couche auxiliaire (422) à partir de Si₃N₄ ou de polysilicium.

12. Procédé selon l'une quelconque des revendications 1 à 11, dans lequel l'épitaxie sélective a lieu dans la plage de température entre 500°C et 1000°C sous une atmosphère de Si-HCI-H.

13. Procédé pour la fabrication d'un transistor bipolaire selon l'une quelconque des revendications 1 à 12,
- dans lequel, dans le substrat (51), en dessous du domaine monocristallin, on forme un domaine de borne de collecteur (52),
- dans lequel on dope le domaine monocristallin de telle sorte que l'on forme un collecteur (55),
- dans lequel, sur la surface du domaine monocristallin, on forme une base (59) et, sur la surface de la base (59), un émetteur (560).

14. Procédé selon la revendication 13,
- dans lequel le domaine monocristallin se termine en hauteur avec la couche de masquage (53),
- dans lequel, sur la surface de la couche de masquage (53), on forme un raccord de base (56) à partir de silicium polycristallin dopé, qui s'étend jusqu'à la surface du domaine monocristallin et qui entoure, sous forme annulaire, le domaine monocristallin,
- dans lequel on forme la base (59) sur la surface du domaine monocristallin,
- dans lequel on munit le raccord de base (56) d'une couche isolante (58) et on munit les côtés qui se tournent vers le domaine monocristallin de revêtements de flancs isolants (57),
- dans lequel, sur la surface de la base (59), on forme l'émetteur (560) par diffusion extérieure à partir d'une couche de polysilicium (561) dopée de manière correspondante.

15. Procédé selon la revendication 14,
- dans lequel, pour la formation de la base (59), après la formation du raccord de base (56) de la couche isolante et des recouvrements de flancs isolants (57), on grave le domaine monocristallin à une profondeur correspondant à la largeur de la base, en formant des gravures sous-jacentes en dessous du raccordement de base (56),
- dans lequel on forme la base (59) par épitaxie sélective sur la surface mise à nu du collecteur (55).

16. Procédé pour la fabrication d'un transistor MOS selon l'une quelconque des revendications 1 à 12,
- dans lequel le domaine monocristallin se termine en hauteur avec la couche de masquage (63),
- dans lequel, dans le domaine monocristallin, on forme une source (64), un drain (65) et un domaine de canal (66),
- dans lequel on forme, au moins sur la surface du domaine de canal (66), un diélectrique de grille (67) et, sur la surface du diélectrique de grille (67), une électrode de grille (68).
